Europäisches Patentamt

(19) European Patent Office

Office européen des brevets

(11) Publication number: **0 098 295**

**B1**

(12) **EUROPEAN PATENT SPECIFICATION**

(45) Date of publication of patent specification: **20.08.86**

(21) Application number: **83900514.7**

(22) Date of filing: **12.01.83**

(86) International application number:
**PCT/US83/00039**

(87) International publication number:
**WO 83/02521 21.07.83 Gazette 83/17**

(51) Int. Cl.⁴: **H 01 B 7/08, H 05 K 1/11, H 05 K 1/14**

(54) **IMPROVED BACKPLANE POWER CONNECTION SYSTEM.**

(30) Priority: **13.01.82 US 339033**
**13.01.82 US 339034**

(43) Date of publication of application:
**18.01.84 Bulletin 84/03**

(45) Publication of the grant of the patent:
**20.08.86 Bulletin 86/34**

(84) Designated Contracting States:
**AT BE CH DE FR GB LI LU NL SE**

(56) References cited:
**DE-A-1 465 167**
**GB-A-1 218 445**
**JP-B-50 040 590**
**US-A-2 876 530**
**US-A-2 955 974**
**US-A-3 312 870**
**US-A-3 396 230**
**US-A-3 459 880**
**US-A-3 499 218**
**US-A-3 516 156**

(73) Proprietor: **ELXSI**
**2334 Lundy Place**
**San Jose CA 95131 (US)**

(72) Inventor: **HOLBERT, Kenneth Wayne**
**802 Ramona Avenue**
**Sunnyvale, CA 94087 (US)**
Inventor: **MASSEY, Edwin Michael**
**1281 Fremont Street**
**San Jose, CA 95126 (US)**

(74) Representative: **Dipl.-Phys.Dr. Manitz Dipl.-Ing.**
**Finsterwald Dipl.-Ing. Grämkow Dipl.-Chem.Dr.**
**Heyn Dipl.-Phys.Rotermund,**
**B.Sc. Morgan Robert-Koch-Strasse 1**
**D-8000 München 22 (DE)**

(56) References cited:
**US-A-3 663 866**
**US-A-3 680 005**
**US-A-3 893 233**
**US-A-4 362 899**

**IBM Technical Disclosure Bulletin,Issued January 1970,S.C.RIELY,Laminated Bus System**

Courier Press, Leamington Spa, England.

## Description

The present invention relates to a power distribution system having a laminated series of circuit boards comprising, in order, at least a first conductive layer, a first dielectric layer, a second conductive layer and a second dielectric layer, wherein said second conductive and dielectric layers extend transversely beyond said first conductive and dielectric layers to define a substantial extended exposed flat surface portion of said second conductive layer; and also to a method of fabricating the same.

A power distribution system of this kind in the form of a laminated bus system is disclosed in IBM Technical Disclosure Bulletin volume 12, No. 8, January 1970, pages 1268 and 1269.

The known power distribution system is intended for electronic packaging and in the described arrangement is used to supply power to a circuit board consisting of a plurality of alternating conductive and insulating layers. For this purpose the circuit board assembly is placed against the bus system so that the conducting and insulating layers of the circuit board assembly are parallel to the conductive and dielectric layers of the bus system, and a plurality of pins extend from the circuit board assembly through holes in the bus system to the exposed surface portions of the bus system to which they are permanently connected by soldering.

The stepped arrangement of the laminated bus system provides space for the soldered joints.

The power feed into the conductive layers takes places via tabs which can be connected to suitable voltage terminal blocks by means of screws. The tabs are constituted by extended relatively narrow portions of the pairs of conductive and dielectric layers which go to make up the bus system.

The prior art laminated bus system is clearly not intended for use as a computer backplane.

A computer system backplane typically comprises a plurality of conductive layers held rigidly in spaced parallel relation by an interleaved plurality of dielectric layers. While a given dielectric layer has equal significance with respect to the two conductive layers flanking it, one sometimes finds it convenient to conceptualize the backplane as comprising a plurality of coextensive circuit board layers laminated to one another, each layer being of composite construction, including a conductive layer and a dielectric layer. The backplane carries a plurality of parallel multi-terminal sockets that receive in an edgewise manner the circuit boards (called "plugboards") on which the computer system components are constructed. Some of the backplane conductive layers are used for signal propagation, and comprise a relatively large number of separate conductive traces running between the parallel transverse sockets. Others of the conductive layers are so called power planes that provide the fixed voltage levels necessary for system operation, and are generally in the form of solid sheets of conductive material (typically copper).

Each socket includes a large plurality of pins that pass through small plated holes bored through all the layers and make electrical contact with a desired one of the backplane conductive layers. Where a connection to a given layer is not required, a region surrounding the hole through that particular conductive layer is insulated to prevent the pin from making contact. The plated holes are sized relative to the connector pins for a press fit.

Power supply connections are made in a generally similar manner, but on a larger scale. For example, the plated bore for the power plane connection is of a diameter typically on the order of 6,5 mm (a quarter inch) in diameter, and a solid wire of comparable diameter is soldered in.

It will be appreciated that current is supplied to or drawn from the power plane over a relatively small area, leading to relatively large local current densities. Accordingly, while the prior art backplane power distribution systems tend to be suitable for currents of the order of 20 amps, they are not suitable when it is desired to supply considerably larger currents (perhaps 500 amps). This same disadvantage would apply to the laminated bus system described in the IBM Technical Disclosure Bulletin as cited above.

It is an object of the present invention to provide a backplane power distribution system characterized by generally uniform current densities, thus according it the capability of handling very high levels of current.

In order to satisfy this object the present invention provides a power distribution system of the kind known from the IBM Technical Disclosure Bulletin cited above and is characterized in that, in a backplane power distribution system, an elongate bus bar having a flat side surface is mounted with that flat side surface in direct contact with said exposed flat surface portion to facilitate electrical connection thereto.

Further preferred embodiments of the invention are defined in the subordinate claims 2 to 8.

The fabrication of a backplane having the claimed configuration is preferably carried out by laminating, in order, the conductive and dielectric layers to produce a rigid laminated structure with the first and second conductive and dielectric layers generally coextensive; and by removing a portion of the first conductive and dielectric layers to leave a substantial area of the second conductive layer exposed. Further developments of this method are set forth in the further subordinate claims 10 to 14.

The requirement that the layers be laminated to produce the rigid structure having coextensivity arises from the nature of the layers themselves prior to lamination. More particularly, the dielectric layer of a given composite layer initially comprises partially cured prepreg material having limited rigidity. During the lamination, under conditions of heat and pressure, the dielectric layer is cured and becomes rigid.

The main advantage of the present invention is that large currents may be supplied to the various power planes. This arises since the bus bar makes good electrical contact with its respective power plane over an extended area (typically many square inches). Furthermore, since the bus bars are typically bolted to the exposed power plane, they may be easily removed and replaced.

It should also be pointed out that a laminated bus bar is known from US—A—3,893,233 in which a plurality of relatively thin metallic sheets are interleaved with a like plurality of thinner metallic sheets with one set of sheets serving as ground planes whereas the other set of sheets serve as power signal conductors. Moreover, the conductive sheets are electrically separated from one another by a plurality of identical thin insulating members. The metallic sheets of one set of conductors have rectangular tabs along one side edge which overlie rectangular slots provided between corresponding rectangular tabs on the other set of conductors.

Terminal posts extend through aligned tabs of each of the two sets of conductors and the entire bus bar assembly is encapsulated in an epoxy encapsulant. As result it can be seen that the edges of the one set of conductors do not extend transversely beyond the edges of the other set of conductors, or at most only do so locally, and furthermore that they are not exposed in the manner proposed herein. Furthermore, the laminated bus bar of US—A—3,893,233 is not suitable for a computer backplane.

For the sake of completeness attention should also be drawn to another laminated bus bar assembly shown in GB—A—1,218,445 in which a plurality of sheet-like insulators and conductors are arranged in a stepped arrangement, there being three conductors one for each phase of a three phase supply. Components to be supplied with power are connected to the individual faces by metal stems or tongues attached to the individual conductors. These metal stems or tongues represent the connections to the components to be driven and cannot be equated with the rectangular bus bars proposed by the present invention.

For a further understanding of the nature and advantages of the present invention, reference should be made to the remaining portions of the specification and to the attached drawings in which:

Fig. 1 is a sectioned isometric view of an edge region of a backplane according to the present invention with the thickness greatly exaggerated relative to the transverse dimensions;

Fig. 2 is a cross-sectional view of a portion of the backplane edge region; and

Fig. 3 is an isometric view of the backplane showing the power supply connections.

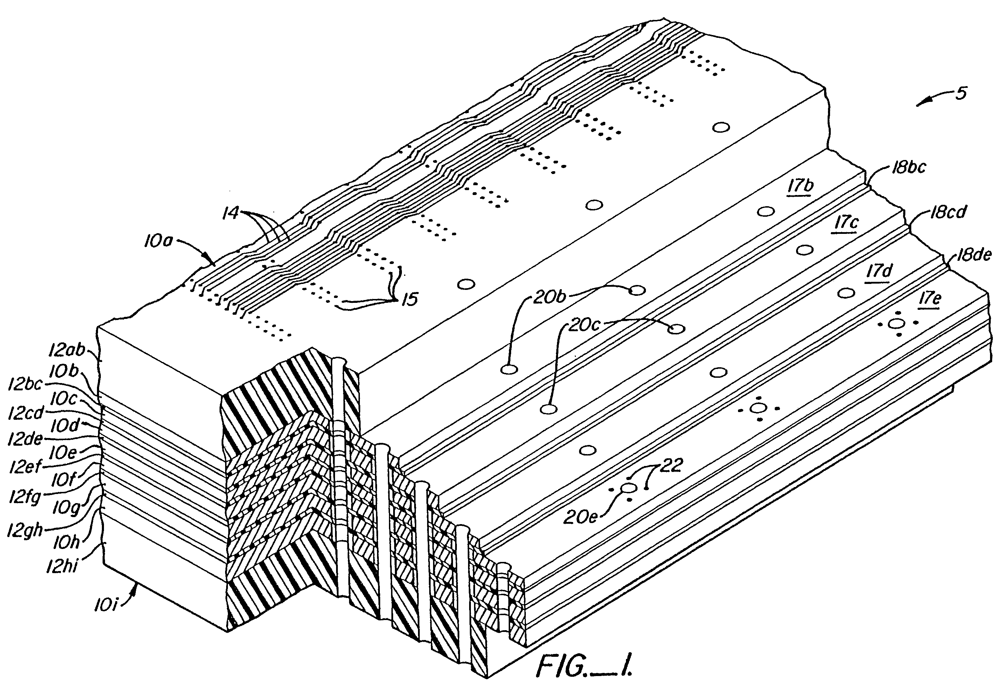

Fig. 1 is a sectioned isometric view of portions of a backplane 5 according to the present invention. Backplane 5 is a laminated structure comprising a plurality of alternating conductive layers 10a—i and interleaved dielectric layers 12ab, 12bc, ... and 12hi. The conductive layers are typically copper while the dielectric layers are fiberglass-epoxy composites. The numbering scheme with respect to the conductive and dielectric layers is such that each conductive layer has a single letter associated with it, and each dielectric layer has associated therewith the two letters that are associated with the immediately neighboring conductive layers. It is important to note that the thickness of back plane 5 has been exaggerated approximately fifteen times relative to the transverse dimensions in order to show all the layers clearly. This exaggeration is necessary since the conductive layers are normally less than about 0.5 mm (0.020 inches) thick.

As is well known, such a backplane is typically used to provide a communications medium among various functional units in a computer system. To this end, conductive layers 10a and 10i (latter not explicitly shown) are signal layers while layers 10b—h are so-called power planes for providing particular DC voltage levels to the functional units. Signal layers 10a and 10i are not solid layers, but rather each comprises a plurality of discrete conductive traces 14. For clarity, the thickness of the signal layers has not been exaggerated in Fig. 1.

Table 1 shows thicknesses of both the conductive and dielectric layers as well as the voltage levels for the power planes. These dimensions and levels are given for illustrative purposes only.

# 0 098 295

TABLE 1

| Layer | Thickness mm (inches) | Voltage |
|---|---|---|
| 10a | 0.03429 (0.00135) | signal |
| 12ab | 0.06858 (0.027) | |
| 10b | 0.27432 (0.0108) | −2v |
| 12bc | 0.127 (0.005) | |
| 10c | 0.27432 (0.0108) | −5v |
| 12cd | 0.127 (0.005) | |
| 10d | 0.13716 (0.0054) | +5v |
| 12de | 0.127 (0.005) | |
| 10e | 0.13716 (0.0054) | gnd |
| 12ef | 0.127 (0.005) | |
| 10f | 0.27432 (0.0108) | gnd |
| 12fg | 0.127 (0.005) | |
| 10g | 0.27432 (0.0108) | gnd |
| 12gh | 0.127 (0.005) | |
| 10h | 0.27432 (0.0108) | gnd |
| 12hi | 0.06858 (0.027) | |
| 10i | 0.03429 (0.00135) | signal |

A particular functional unit is constructed on a circuit board, commonly called a plugboard, having a linear array of generally rectangular plated contacts along an edge. The plugboard edge plugs into a correspondingly configured socket mounted to the back plane. The socket includes resilient contacts for engaging the contacts on the plugboard, and each contact is electrically coupled to a corresponding pin. Neither the plugboards nor the sockets are shown. The backplane is formed with a corresponding array of holes 15 that are plated so that the pin makes contact with a desired one of the back plane conductive layers, whether a signal layer or a power plane. Where connection to a given layer is not required, a region surrounding the hole through that particular conductive layer is insulated.

It can be seen that the edge of backplane 5 is of stepped construction wherein at least some of the conductive layers are of different sizes than others and extend beyond others. More particularly, while conductive layers 10e—h are of the same transverse dimension, layers 10b—e are of increasing size relative to one another, thus defining substantial exposed areas 17b—e of each of power planes 10b—e. These exposed areas may be several square inches. A width in the range 6.4 to 25.4 mm (0.25—1.0 inches) is typical while the logitudinal extent is preferably commensurate with the backplane edge (perhaps 30 cms (1 foot)). Dielectric layers 12bc, 12cd, and 12de each extend a short distance (about 1.27 mm (0.05 inches)) beyond the overlying (shorter) conductive layer to define dielectric steps 18bc, 18cd, and 18de. The significance of the dielectric steps will be described below with respect to the fabrication process.

The significance of exposed areas 17b—e is that rectangular bus bars (to be described below) are bolted thereagainst to make good electrical contact with the respective power planes. To this end, exposed portion 17b is provided with a plurality of bolt holes 20b, with portions 17c—e each being provided with a similar plurality of bolt holes, designated 20c, 20d, and 20e. Each of holes 20e has associated therewith a plurality of smaller satellite holes 22.

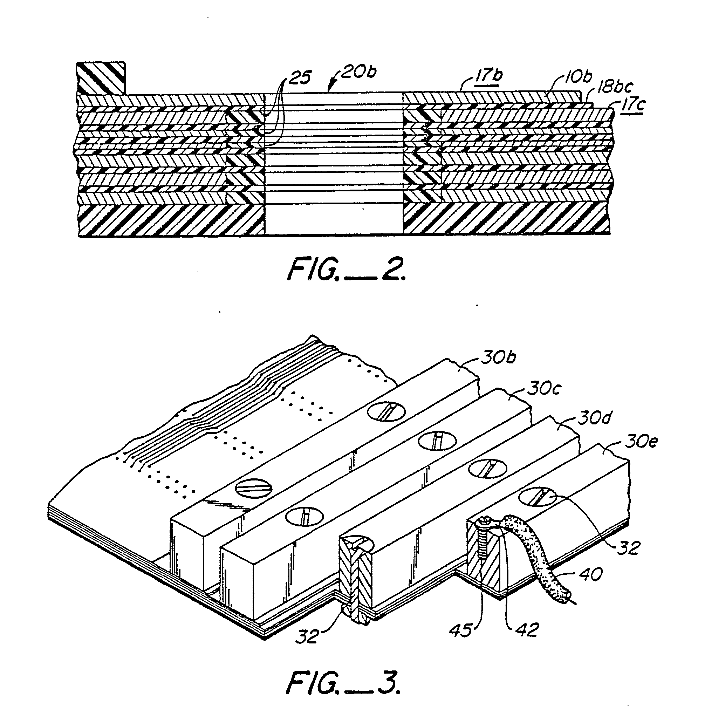

Fig. 2 is a cross-sectional view showing in detail the structure of backplane 5 in the region surrounding one of holes 20b. Other holes are correspondingly configured. While hole 20b extends all the way through the remaining layers of the backplane, it is important that the bolt extending through hole 20b does not make electrical contact with any of the underlying power planes 10c—h (not that hole 20b does not pass near signal plane 10i). Accordingly, each of the power planes except layer 10b has an insulative annulus 25 surrounding hole 20b to prevent the bolt from making contact.

Fig. 3 is an isometric view showing the actual power connections to the power planes. This is accomplished by bolting conductive (e.g., copper) bus bars 30b—e to respective exposed power plane portions 17b—e. Where the exposed portions are about 15.2 mm (0.6 inches bus bars having cross-sectional dimensions of about 12.5 mm by 19 mm (0.5 inches by 0.75) inches may be used. Each bus bar is bolted by a sufficient number of counter-sunk machine screws 32 (e.g., size 10—32) to ensure good electrical contact between the bus bar and the respective power plane. Power cables 40, each having an appropriate lug 42, are then bolted to the bus bars with appropriate machine screws 45. Machine screws 45, in contrast to bolts 32, are held in blind tapped holes so that the bus bar and power cable may be removed as an assembly if desired.

Some of the above-described structural features may be better understood with reference to a preferred fabrication sequence. The first step in this sequence is the provision of the copper and dielectric layers to be later laminated. These may be provided as separate copper and dielectric layers, or as a number of composite and possibly

4

dielectric only layers. Typical composite layers are either a copper-dielectric composite or a copper-dielectric-copper composite. In this context, the dielectric layer is prepreg material, typically itself a sandwich having outer gel-cured layers and an inner completely cured layer. Depending on the nature of the composite layers, there may be some ordinary dielectric layers too. All the layers are initially of the same transverse extent.

Prior to lamination of all the layers to form the backplane, each conductive layer is etched with an appropriate pattern. It should be noted that all the pins in the connectors pass through all the layers, so that where connection of a pin to a given layer is not required, the etching step must remove appropriate material in the vicinity of the hole for the particular pin (the holes are drilled later). For power plane bolt holes 20b—e, where connection is not required, oversized circular regions must be etched in order to accommodate insulative annuli 25.

Thereafter, the various layers are laminated under heat and pressure to form a single rigid assembly. Holes 15 for the connector pins and holes 20b—e for the bus bar bolts are then drilled completely through the rigid laminated structure.

The laminated structure is then subjected to a milling step in order to produce the stepped structure described above. The particular details of the milling are within the purview of ordinarily skilled precision machine stop personnel. It is, however, noted that this milling step does require extreme precision in view of the thinness of the individual layers, and is normally carried out on a numerically controlled milling machine. Although the milling step may be approximately described by saying that the structure is milled to a depth to remove a portion of an overlying composite (conductor-dielectric) layer to expose a portion of the underlying conductive layer, it is noted that the milling step is carried out so as to also form dielectric steps 18bc, 18dc, and 18de. This is significant in view of the subsequent plating step.

An alternate to the direct milling described above makes use of a release agent such as silicone-impregnated tape that is deposited prior to the lamination step on those portions of the copper layers that are to be later exposed. The milling is then carried out to a depth that leaves a very thin dielectric layer (perhaps .0254—.0508 mm (0.001—0.002 inches)) over the portion of the copper that is to be exposed. The thin layer is then separated from the underlying copper and broken off to expose the underlying copper. The release agent allows the separation to occur, while the extreme thinness of the milled layer facilitates the removal. The advantage of this approach is that it does not depend on the copper layer's being absolutely flat.

It will be appreciated that so long as the release agent covers the entire area of the copper layer to be exposed, the milling need not be carried out over the entirety of this area. Rather, the fabrication may be carried out by milling a relatively narrow strip adjacent the step location, leaving the full thickness of the overlying composite layer over the remainder of the area to be exposed. This defines a very thin and relatively narrow web portion which still allows separation of the entire portion of the overlying composite layer to occur at the interface with the release agent.

The milled assembly is then subjected to a plating step such as a solder dip wherein all exposed portions of conductive material are coated with a nonoxidizing layer (e.g. solder). During the plating step, dielectric steps 18bc, 18cd, and 18de act as barriers that prevent the plating material from bridging the gap between successive exposed portions of the conductive layers. In this regard, it is useful to remember that Fig. 1 is greatly exaggerated in thickness, and that the dielectric steps, while having a 1.5875 mm (1/16-inch) transverse dimension, are only approximately 0.127 mm (0.005 inches) thick which would easily be bridged by the plating material in the absence of their transverse extent. During this plating, the dielectric gaps within holes 20e and 22 are plated over so that there results in each a continuous plated bore electrically coupling conductive layers 10e—h. The use of plural thin ground plane layers, rather than a single thick one, is not dictated by any intrinsic advantage, but rather by considerations of ease of manufacture. While plated holes 20e provide an effective conduction path between the various ground planes, satellite holes 22 provide additional contact, increasing the contact by approximately a factor of 2.

In summary, it can be seen that the present invention provides a power plane configuration that permits high current levels. The connections of the bus bars to the backplane are such that the backplane may be disconnected from the power supplies by the expedient of unbolting all the bus bars, leaving the lugs bolted into their respective bus bars.

While the above provides a full and complete disclosure of the preferred embodiment of the invention, various modifications, alternate constructions and equivalents may be employed. For example, while the exposed portions of the conductive layers are preferably rectangular strips along one or more edges of the backplane, other configurations are possible should the requirement arise.

**Claims**

1. A power distribution system having a laminated series of circuit boards comprising, in order, at least a first conductive layer (10b), a first dielectric layer (12bc), a second conductive layer (10c), and a second dielectric layer (12cd), wherein said second conductive and dielectric layers (10c, 12cd) extend transversely beyond said first conductive and dielectric layers (10b, 12bc) to define a substantial extended exposed flat surface portion (17c) of said second conductive layer (10c), characterized in that, in a backplane power distribution system (5), an elongate bus bar (30c) having a flat side surface is mounted with said flat side surface in direct contact with said exposed flat surface portion (17c) to facilitate electrical connection thereto.

2. A power distribution system in accordance with claim 1, characterized in that said first dielectric layer (12bc) extends transversely beyond said first conductive layer (10b) by an amount less than the amount by which said second conductive layer (10c) extends beyond said first conductive layer (10b) to define a plating barrier.

3. A power distribution system in accordance with claim 1, characterized in that said exposed portion (17c) of said second conductive layer is near an edge of said second conductive layer (10c).

4. A power distribution system in accordance with any one of the preceding claims, characterized in that said first and second conductive layers (10b, 10c) are copper; and in that said exposed portion of said second conductive layer is plated with a nonoxidizing conductive material.

5. A power distribution system in accordance with any one of the preceding claims, characterized in that said first and second conductive layers (10b, 10c) are less than about 0.5 mm (0.020 inches) thick, and said exposed portion (17c) has an area of at least 19.35 sq cms (several square inches).

6. A power distribution system in accordance with any one of the preceding claims, characterized in that an initial dielectric layer (12ab) is provided on said first conductive layer (10b) but does not extend transversely to the edge of said first conductive layer (10b), thus defining a substantial extended exposed flat surface portion (17b) thereof;

in that an initial conductive layer (10a) comprising a plurality of discrete signal traces (14) is provided on said initial dielectric layer (12ab);

in that said exposed surface portions (17b, 17c) of said first and second conductive layers (10b, 10c) define respective first and second power planes with a respective said bus bar (30b, 30c) being connected to each of them;

in that means (45) is provided for making power supply connections to said bus bars (30b, 30c) for feeding power into said power planes; and

in that a plurality of holes (15) are formed through said initial, first and second conductive and dielectric layers (10a, 10b, 10c, 12ab, 12bc, 12cd) to allow pin connections to be made through them to said traces (14) and to said power planes.

7. A power distribution system in accordance with any one of the preceding claims, characterized in that the or each said bus bar (30b, 30c, 30d, 30e) is of rectangular cross-section.

8. A power distribution system in accordance with any of the preceding claims, characterized in that the or each said bus bar (30b, 30c, 30d, 30e) is secured to the associated exposed surface portion (17b, 17c, 17d, 17e) by bolts (32) extending through the backplane (5).

9. A method of fabricating a backplane power distribution system (5) in accordance with any one of the preceding claims, characterized by the steps of laminating, in order, the conductive and dielectric layers (10a—10i, 12ab—12hi), to produce a rigid laminated structure with the first and second conductive and dielectric layers (10b, 10c, 12bc, 12cd) generally coextensive; and

removing a portion of the first conductive and dielectric layers (10b, 12bc) to leave a substantial area (17c) of the second conductive layer (10c) exposed.

10. The method of claim 9, characterized in that said removing step comprises the step of milling the rigid laminated structure along an edge region thereof.

11. The method of claim 9, characterized in that said removing step comprises the substeps of:

applying a release agent to the substantial area of the second conductive layer (10c) prior to said laminating step;

milling the rigid laminated structure to leave a thin region of the first dielectric layer (12bc) overlying at least part of the substantial area of the second conductive layer (10c) and separated therefrom by the release agent; and

separating the thin region of the first dielectric layer (12bc) from the second conductive layer to expose the substantial area of the second conductive layer.

12. The method of claim 11, characterized in that said milling substep is carried out over the entire substantial area.

13. The method of claim 10, characterized in that said milling substep is carried out over only a part of the substantial area.

14. The method of any one of claims 9 to 13, characterized in that, said milling step is carried out so as to leave a region (18bc) of said first dielectric layer (12bc) exposed between said first conductive layer (10b) and said substantial exposed area (17c) of said second conductive layer (10c).

**Patentansprüche**

1. Speisungs-Verteilungssystem mit einer Reihe von geschichteten Schaltplatinen mit in dieser Reihenfolge mindestens einer ersten leitenden Schicht (10b), einer ersten dielektrischen Schicht (12bc), einer zweiten leitenden Schicht (10c) und einer zweiten dielektrischen Schicht (12cd), wobei die zweiten leitenden und dielektrischen Schichten (10c, 12cd) sich in Querrichtung über die ersten leitenden und dielektrischen Schichten (10b, 12bc) hinaus erstrecken, um einen freigelegten ebenen Oberflächenabschnitt (17c) wesentlicher Erstreckung der zweiten leitenden Schicht (10c) zu bestimmen, dadurch gekennzeichnet, daß bei einem Rückflächen-Speisungs-Verteilungssystem (5) eine längliche Zuleitungsschiene (30c) mit einer ebenen Seitenflächen mit der ebenen Seitenfläche in direkter Berührung mit dem freigelegten ebenen Oberflächenabschnitt (17c) befestigt ist, um elektrische Verbindung dazu zu ermöglichen.

2. Speisungs-Verteilungssystem nach Anspruch 1, dadurch gekennzeichnet, daß die erste dielektrische Schicht (12bc) sich in Querrichtung über die erste leitende Schicht (10b) um ein Stück hinaus erstreckt, das kleiner als das Stück ist, um welches die zweite leitende Schicht (10c) sich über die erste leitende Schicht (10b) hinaus erstreckt, um eine Plattierungssperre zu bestimmen.

3. Speisungs-Verteilungssystem nach Anspruch 1, dadurch gekennzeichnet, daß der freigelegte Abschnitt (17c) der zweiten leitenden Schicht sich in der Nähe einer Kante der zweiten leitenden Schicht (10c) befindet.

4. Speisungs-Verteilungssystem nach einem der vorangehenden Ansprüche, dadurch gekennzeichnet, daß die ersten und zweiten leitenden Schichten (10b, 10c) Kupfer sind und daß der freigelegte Abschnitt der zweiten leitenden Schicht mit einem nichtoxidierenden leitenden Material plattiert ist.

5. Speisungs-Verteilungssystem nach einem der vorangehenden Ansprüche, dadurch gekennzeichnet, daß die ersten und zweiten leitenden Schichten (10b, 10c) weniger als etwa 0,5 mm (0,020 inches) dick sind, und daß der freigelegte Abschnitt (17c) eine Fläche von mindestens 19,35 cm² (einige Quadratzoll) besitzt.

6. Speisungs-Verteilungssystem nach einem der vorangehenden Ansprüche, dadurch gekennzeichnet, daß eine anfängliche dielektrische Schicht (12ab) an der ersten Leitschicht (10b) vorgesehen ist, die sich jedoch nicht in Querrichtung bis zur Kante der ersten leitenden Schicht (10b) erstreckt und so einen freigelegten ebenen Oberflächenabschnitt (17b) wesentlicher Erstreckung derselben bestimmt;

daß eine anfängliche leitende Schicht (10a) mit einer Vielzahl von diskreten Signalbahnen (14) an der anfänglichen dielektrische Schicht (12ab) vorgesehen ist;

daß die freigelegten Oberflächenabschnitte (17b, 17c) der ersten und zweiten leitenden Schichten (10b, 10c) jeweilige erste und zweite Leistungsebenen bestimmen, wobei mit jeder eine jeweilige Zuleitungsschiene (30b, 30c) verbunden ist;

daß Mittel (45) vorgesehen sind zur Herstellung von Speise-Zuführverbindungen zu den Zuleitungsschienen (30b, 30c) um Leistung in die Speiseebenen einzuführen; und

daß eine Vielzahl von Löchern (15) durch die anfänglichen, ersten und zweiten leitenden und dielektrischen Schichten (10a, 10b, 10c, 12ab, 12bc, 12cd) ausgebildet ist, um die Herstellung von Stiftverbindungen durch diese zu den Bahnen (14) und den Speiseebenen zu erlauben.

7. Speisung-Verteilungssystem nach einem der vorangehenden Ansprüche, dadurch gekennzeichnet, daß die oder jede Zuleitungsschiene (30b, 30c, 30d, 30e) rechtwinkligen Querschnitt besitzt.

8. Speisungs-Verteilungssystem nach einem der vorangehenden Ansprüche, dadurch gekennzeichnet, daß die oder jede Zuleitungsschiene (30, 30c, 30d, 30e) an dem zugeordneten freigelegten Oberflächenabschnitt (17b, 17c, 17d, 17e) mit sich durch die Rückfläche (5) erstreckenden Schrauben (32) befestigt ist.

9. Verfahren zur Herstellung eines Rückflächen-Speisungs-Verteilungssystems (5) nach einem der vorangehenden Ansprüche, gekennzeichnet durch die Schritte des schichtweise Aufeinandersetzens in dieser Reihenfolge der leitenden und dielektrischen Schichten (10a—10i, 12ab—12hi) zur Erzeugung eines starren Schichtaufbaues, wobei die ersten und zweiten leitenden und dielektrischen Schichten (10b, 10c, 12bc, 12cd) sich im wesentlich gleich weit erstrecken, und des Entfernens eines Abschnittes der ersten leitenden und dielektrischen Schichten (10b, 12bc), um eine wesentliche Fläche (17c) der zweiten leitenden Schicht (10c) freigelegt zu belassen.

10. Verfahren nach Anspruch 9, dadurch gekennzeichnet, daß der Schritt des Entfernens den Schritt des Abfräsens des starren Schichtaufbaues längs eines Kantenbereiches desselben enthält.

11. Verfahren nach Anspruch 9, dadurch gekennzeichnet, daß der Schritt des Entfernens folgende Unterschritte enthält:

Aufbringen eines Trennmittels auf die wesentliche Fläche der zweiten leitenden Schicht (10c) vor dem Aufeinanderschicht-Schritt;

Abfräsen des starren Schichtaufbaues, um einen dünnen Bereich der ersten dielektrischen Schicht (12bc), der mindestens teilweise die wesentliche Fläche der zweiten leitenden Schicht (10c) überdeckt und davon durch das Trennmittel abgetrennt ist, zu belassen; und

Abtrennen des dünnen Bereiches der ersten dielektrischen Schicht (12bc) von der zweiten leitenden Schicht, um die wesentliche Fläche der zweiten leitenden Schicht freizulegen.

12. Verfahren nach Anspruch 11, dadurch gekennzeichnet, daß der Unterschritt des Fräsens über die gesamte wesentliche Fläche ausgeführt wird.

13. Verfahren nach Anspruch 10, dadurch gekennzeichnet, daß der Unterschritt des Fräsens über nur einen Teil der wesentlichen Fläche ausgeführt wird.

14. Verfahren nach einem der Ansprüche 9 bis 13, dadurch gekennzeichnet, daß der Schritt des Fräsens so ausgeführt wird, daß ein Bereich (18bc) der ersten dielektrischen Schicht (12bc) zwischen der ersten leitenden Schicht (10b) und der im wesentlichen freigelegten Fläche (17c) der zweiten leitenden Schicht (10c) freigelegt zu lassen.

**Revendications**

1. Système de distribution d'alimentation possédant une série feuilletée de plaquettes de circuit comportant, dans l'ordre, au moins une première couche conductrice (10b), une première couche diélectrique (12bc), une seconde couche conductrice (10c), et une seconde couche diélectrique (12cd), parmi lesquelles lesdites secondes couches conductrice et diélectrique (10c, 12cd) s'étendent transversalement au-delà desdites premières couches conductrice et diélectrique (10b, 12bc) pour définir une partie de surface plane exposée d'étendue importante (17c) de ladite seconde couche conductrice (10c), caractérisé en ce que dans un système de distribution d'alimentation par arrière-plan (5), une barre omnibus allongée (30c) offrant une surface latérale plane, est montée avec ladite surface latérale plane en contact direct avec ladite partie de surface plane exposée (17c) afin de faciliter une connexion électrique avec celle-ci.

2. Système de distribution d'alimentation suivant la revendication 1, caractérisé en ce que ladite première couche diélectrique (12bc) s'étend traversalement au-delà de ladite première couche conductrice (10b) dans une mesure inférieure à celle dont ladite seconde couche conductrice (10c) s'étend au-delà de ladite première couche conductrice (10b) pour définir un barrage au revêtement électrolytique.

3. Système de distribution d'alimentation suivant la revendication 1, caractérisé en ce que ladite partie exposée (17c) de ladite seconde couche conductrice est proche d'un bord de ladite seconde couche conductrice (10c).

4. Système de distribution d'alimentation suivant l'une quelconque des revendications précédentes, caractérisé en ce que lesdites première et seconde couches conductrices (10b, 10c) sont en cuivre, et en ce que ladite partie exposée de ladite seconde couche conductrice est revêtue électrolytiquement avec une matière conductrice inoxydable.

5. Système de distribution d'alimentation suivant l'une quelconque des revendications précédentes, caractérisé en ce que lesdites première et seconde couches conductrices (10b, 10c) ont moins de 0,5 mm (0,020 pouce) d'épaisseur, et ladite partie exposée (17c) a une superficie d'au moins 19,35 cm² (plusieurs pouces carrés).

6. Système de distribution d'alimentation suivant l'une quelconque des revendications précédentes, caractérisé en ce qu'une couche diélectrique initiale (12ab) est prévue sur ladite première couche conductrice (10b) mais ne s'étend pas transversalement jusqu'au bord de ladite première couche conductrice (10b), en définissant ainsi une partie de surface plane exposée d'étendue importante (17b) de celle-ci;

en ce qu'une couche conductrice initiale (10a) comprenant une multiplicité de pistes de signal distinctes (14) est prévue sur ladite couche diélectrique initiale (12ab);

en ce que lesdites parties de surface exposées (17b, 17c) desdites première et seconde couches conductrices (10b, 10c) définissent des premier et second plane d'alimentation respectifs avec une barre omnibus précitée respective (30b, 30c) connectée à chacun d'eux;

en ce qu'un moyen (45) est prévu pour établir des connexions d'alimentation vers lesdites barres omnibus (30b, 30c) afin de fournir une alimentation auxdits plans d'alimentation; et

en ce qu'une multiplicité de trous (15) sont pratiqués dans lesdites couches initiales, premières et secondes couches conductrices et diélectriques (10a, 10b, 10c, 12ab, 12bc, 12cd) pour permettre d'effectuer des connexions par broche à travers elles vers lesdites pistes (14) et lesdits plans d'alimentation.

7. Système de distribution d'alimentation suivant l'une quelconque des revendications précédentes, caractérisé en ce que la ou chaque barre omnibus précitée (30b, 30c, 30d, 30e) a une section transversale rectangulaire.

8. Système de distribution d'alimentation suivant l'une quelconque des revendications précédentes, caractérisé en ce que la ou chaque barre omnibus précitée (30b, 30c, 30d, 30e) est fixée à la partie de surface exposée associée (17b, 17c, 17d, 17e) par des boulons (32) traversant l'arrière-plan (5).

9. Procédé de fabrication d'un système de distribution d'alimentation par arrière-plan (5) suivant l'une quelconque des revendications précédentes, caractérisé par des étapes de feuilletage, dans l'ordre, des couches conductrices et diélectriques (10a—10i, 12ab—12hi), afin de produire une structure feuilletée rigide avec les premières et secondes couches conductrices et diélectrique (10b, 10c, 12bc, 12cd) généralement de même étendue; et

d'enlèvement d'une partie des premières couches conductrice et diélectrique (10b, 12bc) afin de laisser une importante superficie (17c) de la seconde couche conductrice (10c) exposée.

10. Procédé suivant la revendication 9, caractérisé en ce que ladite étape d'enlèvement comprend l'étape de fraisage de la structure feuilletée rigide le long d'une région marginale de celle-ci.

11. Procédé suivant la revendication 9, caractérisé en ce que ladite étape d'enlèvement comprend les sous-étapes de:

application d'un agent de séparation à l'importante superficie de la seconde couche conductrice (10c) préalablement à ladite étape de feuilletage;

fraisage de la structure feuilletée rigide pour laisser une mince région de la première couche diélectrique (12bc) recouvrant une partie au moins de l'importante superficie de la seconde couche conductrice (10c) et séparée de celle-ci par l'agent de séparation; et

séparation de la mince région de la première couche diélectrique (12bc) à partir de la seconde couche conductrice afin d'exposer l'importante superficie de la seconde couche conductrice.

12. Procédé suivant la revendication 11, caractérisé en ce que ladite sous-étape de fraisage est effectuée sur toute l'importante superficie.

13. Procédé suivant la revendication 10, caractérisé en ce que ladite étape de fraisage est effectuée sur une partie seulement de l'importante superficie.

14. Procédé suivant l'une quelconque des revendications 9 à 13, caractérisé en ce que ladite étape de fraisage est effectuée de manière à laisser une région (18bc) de ladite première couche diélectrique (12bc) exposée entre ladite première couche conductrice (10b) et ladite importante superficie exposée (17c) de ladite seconde couche conductrice (10c).

FIG.__1.

0 098 295

*FIG. __ 2.*

*FIG. __ 3.*